# EUROPEAN PATENT APPLICATION

(11) **EP 4 663 368 A1**
(43) Date of publication of application: **17.12.2025**
(21) Application number: 25178799.0
(22) Date of filing: 26.05.2025
(51) Int. Cl.: B28D 5/00

(54) **METHOD FOR MANUFACTURING SEMICONDUCTOR WAFERS**

(30) Priority: 14.06.2024 JP 2024096755
(71) Applicant: DENSO CORPORATION, Kariya-city, Aichi 448-8661 (JP)
(72) Inventor: SASAYAMA, Kazutoshi, Kariya-city, 448-8661 (JP); KANDA, Hirokazu, Kariya-city, 448-8661 (JP); FUJIWARA, Kiyotaka, Kariya-city, 448-8661 (JP)
(74) Representative: Kuhnen & Wacker Patent- und Rechtsanwaltsbüro PartG mbB

(57) **Abstract**

A method for manufacturing a semiconductor wafer includes steps of: preparing a peeling object (30) including a single crystal body (1, 2) of a semiconductor having a pair of major surfaces composed of front and back surfaces, the peeling object having a peeling layer (31) provided along at least one of the major surfaces; applying a tensile stress to the peeling object (30) to cause a first major surface and a second major surface to be separated from each other; forming a stress-concentrated region in the peeling layer (31) positioned inside an outer peripheral edge (13, 23) in a radial direction of which the center is a center axis (CL) orthogonal to the major surface; and propagating cracks from the stress-concentrated region as a starting point, thereby peeling between a first side portion and a second side portion of the peeling object (30) having the peeling layer (31) interposed therebetween in a direction parallel to the center axis (CL).

## Description

### CROSS-REFERENCE TO RELATED APPLICATION

This application is based on and claims the benefit of priority from earlier Japanese Patent Application No. 2024-96755 filed June 14, 2024, the description of which is incorporated herein by reference.

### BACKGROUND

### (Technical Field)

The present disclosure relates to a method for manufacturing semiconductor wafers.

### (Description of the Related Art)

As a related art, a wafer producing method is disclosed. For example, a patent literature JP-A-2016-111143 discloses a wafer producing method including a starting point formation process and a wafer separation process. In the starting point formation process, a converging point of a laser beam having a wavelength to which the ingot, fixed on the supporting table, has transparency, is positioned at a depth position corresponding to a wafer thickness from a surface of the ingot, and the laser beam is irradiated on the surface while causing the converging point and the ingot to be relatively moved. Thus, a modified layer and a crack propagated from the modified layer along the c-surface are formed. In the wafer separation, an external force is applied to separate a plate-shaped object of which the thickness corresponds to the thickness of a wafer to be produced from the ingot with respect to the starting point configured of the modified layer and the crack.

Specifically, in the above-described patent literature, the wafer separation process is performed by a pressing mechanism. The pressing mechanism is provided with a head that moves in a vertical direction due to a moving mechanism and a pressing member that rotates relative to the head. The pressing mechanism is positioned above the ingot fixed on the supporting table and the head is moved down such that the pressing member is brought into contact, under pressure, with the surface of the ingot. In the case where the pressing member is caused to rotate in a state of being pressed against with the ingot surface (i.e. pressure contact), a torsional stress is generated on the ingot, and the ingot is fractured from the starting point where the modified layer and the cracks were formed, whereby a wafer can be separated from the ingot.

Since sagging or chipping occurs in an outer peripheral part of the ingot due to a griding process or a polishing process and stress is concentrated at the sagging part or the chipped part, cracks may be produced in the outer peripheral part at a position different from the intended starting point, thereby lowering a material yield. The present disclosure has been achieved in light of the above-described circumstances. In other words, the present disclosure provides a technique capable of favorably performing a peeling process after irradiating a laser beam in a so-called laser slicing process applied to a single crystal body of a semiconductor.

### SUMMARY

In one aspect of the present disclosure, a method for manufacturing a semiconductor wafer includes steps of:
preparing a peeling object (30) including a single crystal body (1, 2) of a semiconductor formed in a column shape or a plate shape having a pair of major surfaces composed of front and back surfaces, the peeling object having a peeling layer (31) provided along the major surface;
applying a tensile stress to the peeling object to cause a first major surface and a second major surface of the pair of major surfaces to be separated from each other;
forming, with an application of the tensile stress to the peeling object, a stress-concentrated region in the peeling layer which is positioned inside an outer peripheral edge (13, 23) in a radial direction of which the center is a center axis (CL) orthogonal to the major surface of the single crystal body; and
propagating cracks from the stress-concentrated region as a starting point, thereby peeling between a first side portion and a second side portion of the peeling object having the peeling layer interposed therebetween in a direction parallel to the center axis.

Note that, in each section of the present application documents, each constituent may be given a reference sign in parentheses. In this case, the reference sign merely indicates an example of the correspondence between the constituent and a specific configuration described in the embodiments described later. Hence, the present disclosure is not limited by the description of the reference signs.

### BRIEF DESCRIPTION OF THE DRAWINGS

In the accompanying drawings:
Fig.1 is a conceptual diagram showing an overall manufacturing method of semiconductor wafers according to a first embodiment of the present disclosure;
Fig.2 is a side view diagram showing an overall configuration of a peeling jig used for a peeling process performed in the semiconductor manufacturing method shown in Fig.1;
Fig.3 is a partial side-cross-sectional view diagram showing a configuration example of an upper jig shown in Fig.2;
Fig.4 is a diagram showing a stress distribution inside the ingot when using the upper jig shown in Fig.3;
Fig.5 is a partial side-cross-sectional view diagram showing another configuration example of an upper jig shown in Fig.2;
Fig.6 is a diagram showing a stress distribution inside the ingot when using the upper jig shown in Fig.5;
Fig.7 is a conceptual diagram showing an overall manufacturing method of semiconductor wafers according to a second embodiment of the present disclosure;
Fig.8 is a plan view of the ingot shown in Fig.7;
Fig.9 is a side view showing a structure of a peeling object in a semiconductor manufacturing method according to a third embodiment of the present disclosure;
Fig.10 is a partial side-cross-sectional view diagram showing a structure of a peeling object in a semiconductor manufacturing method according to a fourth embodiment of the present disclosure; and
Fig.11 is a partial side-cross-sectional view diagram showing a structure of a peeling object in a semiconductor manufacturing method according to a fifth embodiment of the present disclosure.

### DETAILED DESCRIPTION OF THE PREFERRED EMBODIMENTS

### (Embodiments)

Hereinafter, with reference to the drawings, embodiments of the present disclosure will be described. Note that the following description of the embodiments and their modifications and the drawings are schematic or simplified in order to concisely explain the contents of the present disclosure, and are not intended to limit the contents of the present disclosure. Therefore, the description in the drawings in the present application does not necessarily coincide with the specific configuration of the actual manufactured and sold object based on the implementation of the present disclosure. In other words, unless the applicant explicitly limits it through the prosecution history of the present application, the present disclosure should not be interpreted in a limited manner by the descriptions in the drawings and the corresponding descriptions of the configuration of each element and its function or operation described below.

### (First Embodiment)

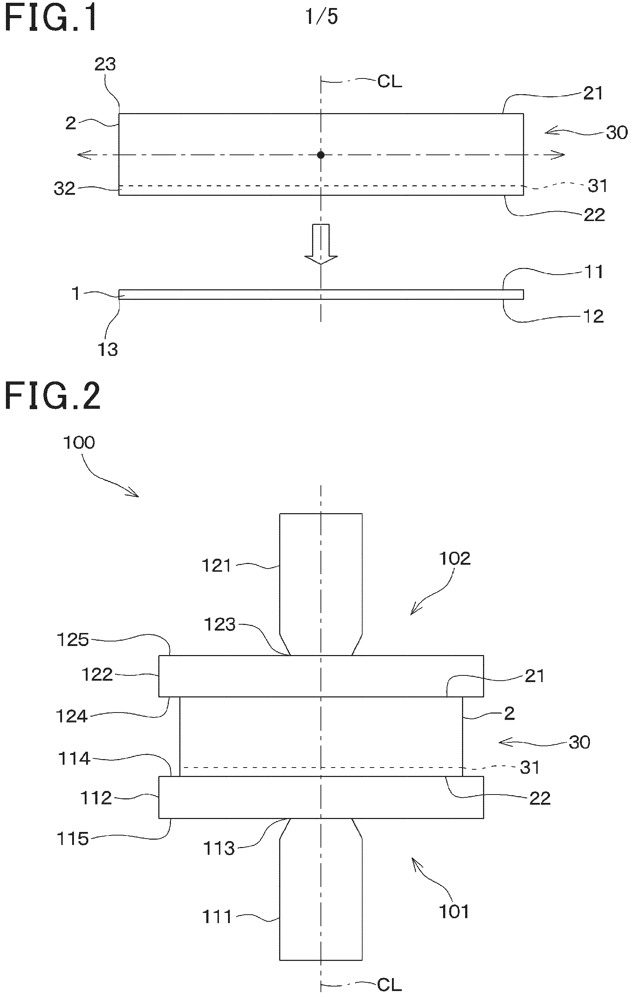

Referring to Fig. 1, the semiconductor wafer manufacturing method according to the first embodiment utilizes a so-called laser slicing technique to cut out a semiconductor wafer 1 from a semiconductor ingot 1 as a single crystal body of a semiconductor formed in a column shape or a plate shape. The semiconductor wafer 1 and the semiconductor ingot 2 are assumed to be a SiC single crystal body. Note that an illustration and explanation of an orientation flatness or a notch which is usually provided in the semiconductor wafer 1 or the semiconductor ingot 2 will be omitted in view of simplification of illustration and explanation.

The semiconductor wafer 1 is formed in a thin-plate shape having substantially the same thickness, having a wafer surface 11 and a wafer back surface 12 as a pair of major surfaces composed of front and back surfaces arranged in a thickness direction. The major surface refers to a surface substantially orthogonal to a thickness direction of a plate-like structure such as a semiconductor wafer 1, or a surface substantially orthogonal to the height direction of a column structure such as a semiconductor ingot 2. The major surface can be referred to as an upper surface, a lower surface, an apex surface, a bottom surface, or a plate surface.

Further, the semiconductor wafer 1 has a wafer outer peripheral edge 13 as an end face formed in a cylindrical surface shape having a center axis CL parallel to the thickness dimension. In other words, the semiconductor wafer 1 is formed such that the wafer outer peripheral edge 13 as an outer peripheral edge in the radial direction is formed in a circular shape in plan view parallel to the central axis CL. Note that 'cylindrical surface shape' and 'circular shape' are not strictly defined such that an orientation flatness or a notch is included as described above. Moreover, 'radial direction' is defined as a direction in a surface orthogonal to the center axis CL, radially extending with respect to the center axis CL as the center thereof. In other words, 'radial direction' is, when drawing a virtual circle in a virtual plane of which the normal line is the center axis CL where the center point of the virtual circle is a cross point between the virtual plane and the center axis CL, a direction in which the radius of the virtual circle extends from the center point. Note that the radial direction also corresponds to an in-plane direction. The in-plane direction refers to any directions orthogonal to the center axis CL. That is, the in-plane direction is a direction along the wafer surface 11 or the wafer back surface 12.

In Fig.1, in view of simplification of an illustration and an explanation, the semiconductor wafer 1 and the semiconductor ingot 2 are illustrated in side view in a state where the semiconductor wafer 1 and the semiconductor ingot 2 are arranged co-axially with respect to the common center axis CL. Also, in Fig.1, the radial direction of the semiconductor ingot 2 is indicated by an arrow of a dashed line. The in-plane direction of the semiconductor ingot 2 is a direction along a first ingot major surface 21, a second ingot major surface 22 and a peeling layer 31 which will be described later. The direction parallel to the center axis CL is referred to as 'axial direction'.

The semiconductor ingot 2 is formed in substantially cylindrical shape of which the axial center is the center axis CL. The semiconductor ingot 2 has a first ingot major surface 21 and a second ingot major surface 22 as a pair of front and back surfaces arranged in a thickness direction or a height direction, and an ingot outer peripheral edge 23 as a side face formed in a cylindrical surface shape of which the axial center is the center axis CL.

In the semiconductor wafer manufacturing method according to the present embodiment, a semiconductor ingot 2 provided with a peeling layer 31 is prepared as a peeling object 30. The peeling layer 31 serves as a portion likely to be fractured compared to other portions, which will be a starting point of brittle fracture caused by crack propagation along the in-plane direction due to application of an external force. In the case where the peeling layer 31 is provided inside the semiconductor ingot 2, the peeling layer 31 serves as a portion having a fracture stress smaller than other portions in the semiconductor ingot 2. The fracture stress refers to, typically, a tensile fracture stress for example. Since the peeling layer 31 is for forming a major surface after the peeling process, the peeling layer 31 is preferably formed as a peeling surface having a planar shape along the in-plane direction (i.e. substantially parallel to the in-plane direction). However, the peeling layer 31 is actually formed in a thin layered shape extending in the in-plane direction, because the formation position varies in the depth direction when being formed. Note that the peeling layer 31 may also be referred to as 'peeling surface', 'separation surface', and 'separation layer'.

Specifically, for example, the converging point of a laser beam for which the ingot has transparency at that wavelength is positioned at a predetermined depth from the second ingot major surface 22, and the laser beam is irradiated on the second ingot major surface 22 while causing the converging point and the ingot to be relatively moved. The predetermined depth corresponds to a thickness in which a thickness corresponding to a processing margin of the polishing or the gliding after the peeling process is added to a required thickness of the semiconductor wafer 1.

Thus, the peeling layer 31 in which plenty of laser irradiation marks are formed in the in-plane direction is provided along the second ingot major surface 22 as the laser irradiation surface. The laser irradiation marks are composed of a modified layer formed when SiC is separated into Si and carbon by the irradiation of the laser beam and cracks propagating along the c surface from the modified layer. For a forming method of the modified layer 31 on the semiconductor ingot 2 using laser irradiation, since it is a well-known or publicly known technique (e.g. JP-A-93046), detailed explanation in the present specification will be omitted.

Then, in the manufacturing method according to the present embodiment, a tensile stress is applied to the peeling object 30 to cause the first ingot major surface 21 and the second ingot major surface 22 to be separated from each other along the axial direction, thereby causing cracks in the peeling layer 31 to be propagated along the in-plane direction. Thus, a peeling object layer 32 which becomes the semiconductor wafer 1 can be separated from the semiconductor ingot 2. The peeling object layer 32 is a portion positioned closer to the second ingot major surface 22 in the axial direction than a portion where the peeling layer 31 is positioned. Specifically, the peeling object layer 32 is a portion between the peeling layer 31 and the second ingot major surface 22, having a predetermined thickness corresponding to the above-described predetermined depth.

Here, for a side surface (outer peripheral surface) of the cylindrical shaped semiconductor ingot 2 that constitutes the ingot outer peripheral edge 23, a shape defect such as sagging or chipping caused by a griding or a polishing when forming the outer shape of the semiconductor ingot 2 to be a cylindrical shape may be present. In the case where stress is concentrated at the shape defect part, cracks occur at a portion different from the peeling layer 31 as the intended starting point with respect to the axial direction, and propagate from the outer peripheral surface, thereby possibly lowering the material yield. Further, the transparency is unstable at the outer peripheral part of the semiconductor ingot 2. Hence, when attempting to perform peeling from the outer peripheral edge of the peeling layer 31 in the radial direction (i.e. ingot outer peripheral edge 23) as a starting point, an external stress required for the peeling becomes unstable.

In this respect, according to the present embodiment, the starting point of peeling is set to be further inside than the ingot outer peripheral edge 23 in the in-plane direction (i.e. radial direction), whereby the peeling process can be more favorably performed than in the conventional art. Specifically, according to the present embodiment, a stress-concentrated region is formed in the peeling layer 31 which is positioned inside the ingot outer peripheral edge 23 in the radial direction to propagate cracks from the stress-concentrated region as the starting point, whereby the peeling object layer 32 is separated (cut) from the semiconductor ingot 2.

Fig.2 shows a state where the semiconductor ingot 2 is attached to a peeling jig 100 for performing a peeling process with a stress-concentrated region formed in the peeling layer 31 inside the ingot outer peripheral edge 23 in the radial direction. According to the present embodiment, the peeling jig 100 is utilized to perform the peeling process. Hereinafter, the configuration and the function of the peeling jig will be described.

The peeling jig 100 includes a lower jig 101 and an upper jig 102. The semiconductor ingot 2 as the peeling object 30 is disposed between the lower jig 101 and the upper jig 102 in a state where the second ingot major surface 22 and the lower jig 101 face each other and the first ingot major surface 21 and the upper jig 102 face each other. In Fig.2, in view of simplification of illustration and explanation, although the axial direction along which the lower jig 101, the semiconductor ingot 2 and the upper jig 102 are arranged, that is, a direction along which the center axis CL extends, is defined as a vertical direction in the drawing, the present disclosure is not limited to the above definition. In other words, the vertical direction in the drawing is not limited to a direction parallel to the direction of action of gravity. The terms of 'upper' or 'lower' of lower jig 101 and the upper jig 102 are conveniently utilized for illustrating Fig.2, but can be also referred to as a first jig and a second jig.

The lower jig 101 includes a lower jig tensile joint 111 and a lower jig body 112. The lower jig tensile joint 111 as a first tensile joint according to the present disclosure is connected to the lower jig body 112 at the lower jig connection part 113. The lower jig tensile joint 111 is formed in a circular shape or an elliptic cylindrical shape or a polygonal prism shape and is provided protruding towards a lower part in the drawing from the lower jig body 112 along the center axis CL. The lower jig tensile joint 111 is configured to be connected to a tensile cutout apparatus (not shown).

The lower jig body 112 as the first jig body of the present disclosure is configured to support the peeling object 30, that is, the semiconductor ingot 2 in the second ingot major surface 22 side. The lower jig body 112 includes a lower jig surface 114 as a surface in the peeling object 30 side, and a lower jig back surface 115 as the lower jig connection part 113 side. The lower jig surface 114 and the lower jig back surface 115 are formed in a planar shape orthogonal to the center axis CL. In order to fix the peeling object 30 on the lower jig surface 114, adhesive or a double-sided tape may be used or a suction device using negative air pressure may be used. Since such a method for fixing is a publicly known or well-known technique, illustration or detailed explanation thereof will be omitted.

The upper jig 102 includes an upper jig tensile joint 121 and an upper jig body 122. The upper jig tensile joint 121 as a second tensile joint according to the present disclosure is connected to the upper jig body 122 at the upper jig connection part 123. The upper jig tensile joint 122 is formed in a circular shape or an elliptic cylindrical shape or a polygonal prism shape and is provided protruding towards an upper part in the drawing from the upper jig body 122 along the center axis CL. The upper jig tensile joint 121 is configured to be connected to a tensile cutout apparatus (not shown).

The upper jig body 122 as the second jig body of the present disclosure is configured to support the peeling object 30, that is, the semiconductor ingot 2 in the first ingot major surface 21 side. The upper jig body 122 includes an upper jig surface 124 as a surface in the peeling object 30 side, and an upper jig back surface 125 as the upper jig connection part 123 side. The upper jig surface 124 and the upper jig back surface 125 are formed in a planar shape orthogonal to the center axis CL. The upper jig surface 124 is formed in the same shape as the lower jig surface 114. Similarly, the upper jig back surface 125 is formed in the same shape as the lower jig back surface 115. In order to fix the peeling object 30 on the upper jig surface 124, adhesive or a double-sided tape may be used or a suction device using negative air pressure may be used.

For the peeling jig 100, the lower jig tensile joint 111 and the upper jig tensile joint 121 are coaxially arranged with respect to the axis center parallel to the center axis CL in a state where the peeling object 30 is disposed between the lower jig 101 and the upper jig 102. Further, according to the present embodiment, the lower jig tensile joint 111 and the upper jig tensile joint 121, that is, the lower jig connection part 111 and the upper jig connection part 123 are arranged inside the ingot outer peripheral edge 23 in the radial direction. Specifically, according to a configuration example shown in Fig.2, the lower jig tensile joint 111 and the upper jig tensile joint 121 are coaxially arranged with respect to the center axis CL. Then, the lower jig 101 and the upper jig 102, when causing the upper jig surface 124 and the lower jig surface 114 having the same shape to come into contact without causing a positional deviation, are symmetrically provided with respect to the contact surface therebetween.

According to the present embodiment, a tensile cutout apparatus (not shown) is utilized to apply an external force to the lower jig tensile joint 111 and the upper jig tensile joint 121, thereby causing the lower jig tensile joint 111 and the upper jig tensile joint 121 to be separated from the semiconductor ingot 2. Specifically, the tensile cutout apparatus applies the external force to the lower jig tensile joint 111 and the upper jig tensile joint 121 so as to be separated from each other along the axial direction. For example, the tensile cutout apparatus supports either one of the lower jig tensile joint 111 or the upper jig tensile joint 121 to be fixed thereto and causes the other one to be separated (i.e. pull) from either one of the lower jig tensile joint 111 or the upper jig tensile joint 121. Thus, peeling can be produced in the peeling layer 31 from a starting point which is a position corresponding to the lower jig tensile joint 111 and the upper jig tensile joint 121 in the in-plane direction.

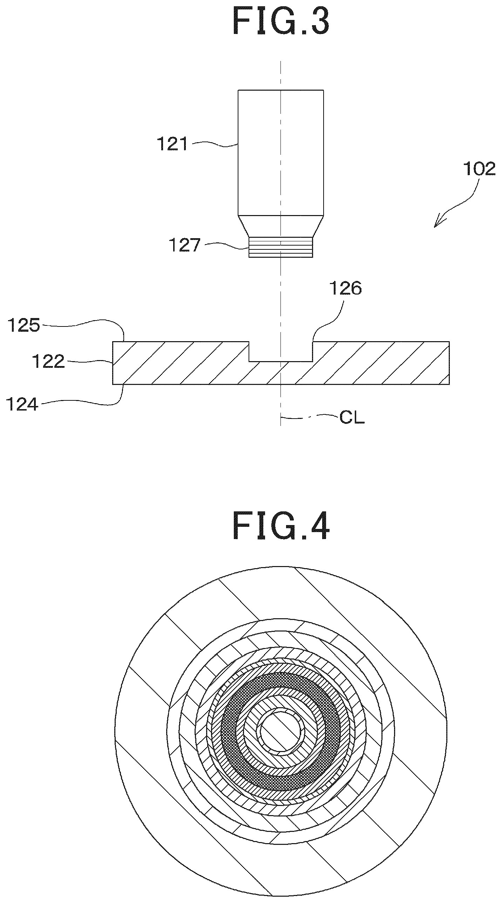

Fig.3 shows a configuration example of the upper jig 102. As shown in Fig.3, the upper jig tensile joint 121 and the upper jig body 122 may be produced as individual parts or constituents and then they are mutually coupled. According to the configuration example shown in Fig.3, an engaging hole 126 that opens in the axial direction is formed in an upper jig back surface 125 side. Specifically, the engaging hole 126 is formed as a screw hole. On the other hand, an engaging part 127 is provided at the upper jig tensile joint 121 to be engaged with the engaging hole 126 while being inserted thereto. The engaging part 127 is configured as a screw part having a cylindrical shape which is screwed to the engaging hole 126 as the screw hole.

The semiconductor ingot 2 as the peeling object 30 is put between the upper jig 102 configured as shown in Fig.3 and the lower jig 101 having the same configuration as that of the upper jig 102. Then, an external force is applied so as to separate the lower jig tensile joint 111 and the upper jig tensile joint 121. The stress distribution of the axial direction inside the semiconductor ingot 2 with respect to the in-plane direction will be shown in Fig.4. In Fig.4, the stress magnitude is indicated by a shade of hatching. In this case, as shown in Fig,4, a ring-shaped stress concentration part is produced corresponding to a diameter of the upper jig connection part 123 of which the center is the center axis CL, that is, a diameter of a screw part between the engaging hole 126 and the engaging part 127.

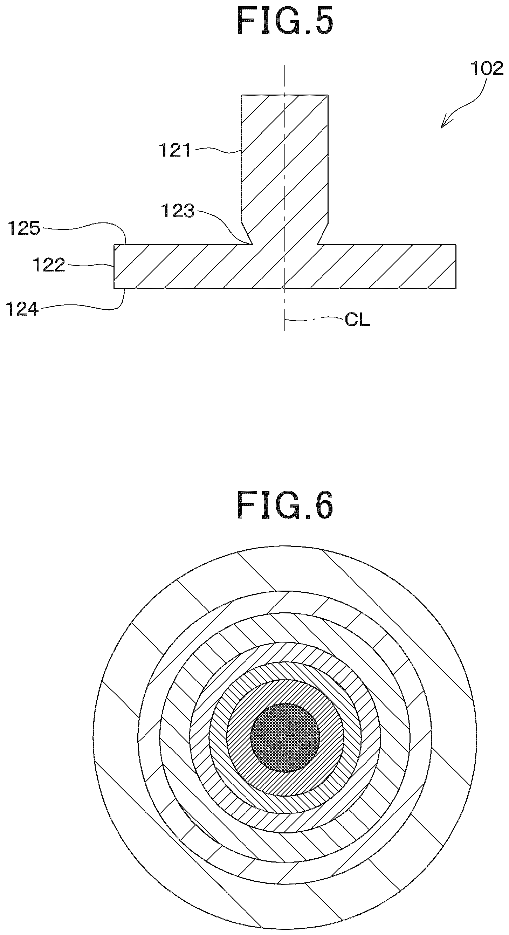

Fig.5 shows other configuration example of the upper jig 102. As shown in Fig.5, the upper jig tensile joint 121 and the upper jig body 122 are integrally formed. Specifically, for example, the upper jig tensile joint 121 and the upper jig body 122 may be integrated by the same material without any joints.

The semiconductor ingot 2 as the peeling object 30 is disposed between the upper jig 102 configured as shown in Fig.5 and the lower jig 101 having the same configuration as that of the upper jig 102. Then, an external force is applied so as to separate the lower jig tensile joint 111 and the upper jig tensile joint 121. The stress distribution of the axial direction inside the semiconductor ingot 2 with respect to the in-plane direction will be shown in Fig.6. Also, in Fig.6, a magnitude of the stress is indicated by the shade of hatching. In this case, as shown in Fig.6, a tensile stress becomes larger in a region inside a circle corresponding to an outer diameter of the upper jig connection part 123 of which the center is the center axis CL. In other words, a stress concentration part is produced in that region.

According to the above-described configuration examples, referring to Fig.2, a stress-concentrated region is formed in a center part of the peeling layer 31 with respect to the in-plane direction, causing cracks to be propagated from the starting point as the stress-concentrated region. Hence, appropriate peeling, that is, cutting in the peeling layer 31, can be simply and stably accomplished using the peelingjig 100 having a simple configuration.

### (Second Embodiment)

Hereinafter, a second embodiment of the present disclosure will be described. In the following description of the second embodiment, configurations different from those in the above-described first embodiment will mainly be described. Moreover, in the first and second embodiments, the same reference numbers are applied to mutually identical or equivalent configurations. Hence, for the configurations having the same reference numbers in the description of the following second embodiment, explanation of the first embodiment is applied unless a technical inconsistency is present or any additional explanation is required. The same applies to the third to fifth embodiments and modifications examples.

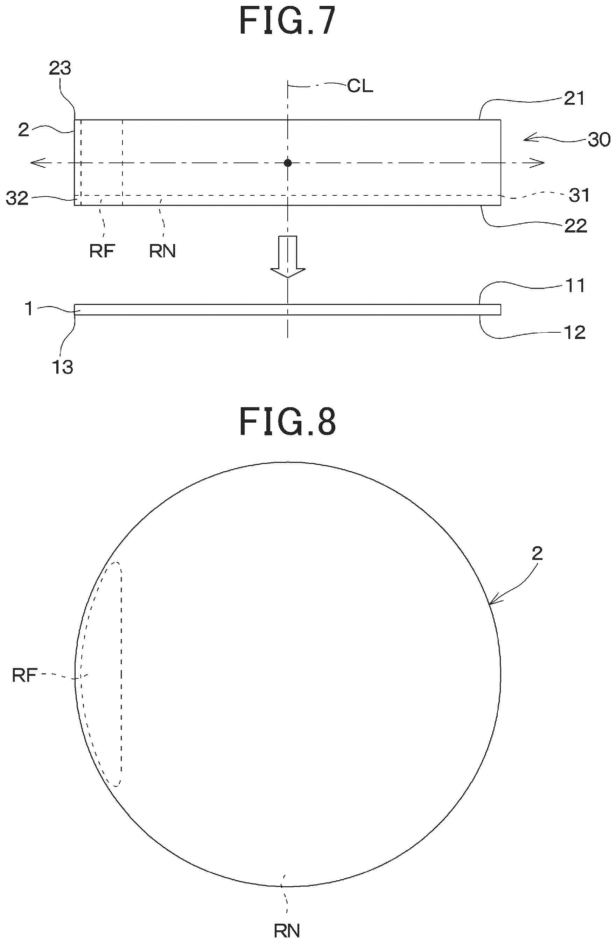

As shown in Figs.7 and 8, a facet region RF may be formed in the semiconductor wafer 1 or the semiconductor ingot 2. In the facet region RF, a transmittance of the laser beam used for a laser slicing is lower than that in a non-facet region RN located outside the facet region RF. Hence, in the facet region RF, cracks are likely to propagate depending on the laser irradiation method and an amount of external force required for the cutoff is lowered. Accordingly, setting the facet region RF to be a starting point of the cutoff, favorable cutoff can be performed while lowering the cutoff stress.

In this respect, according to the present embodiment, referring to Fig.2, the peeling jig is configured such that positions of the lower jig tensile joint 111 and the upper jig tensile joint 121 in the in-plane direction are variable. Then, the peeling jig 100 is configured to change the positions of the lower jig tensile joint 111 and the upper jig tensile joint 121 in the in-plane direction, whereby a stress-concentrated position when performing the cutoff (i.e. peeling), can be set at an arbitrary position.

Specifically, for example, the upper jig 102 may be configured such that the upper jig tensile joint 121 and the upper jig body 122 are capable of being attached or detached using a magnetic force. Alternatively, for example, a plurality of engaging holes 126 shown in Fig.3 may be formed in the upper jig 102. In this case, respective engaging holes 126 are provided at mutually different positions in the in-plane direction. The same applies to the lower jig 101.

According to the present embodiment, a stress-concentrated position can be set in a local region in which a cutoff stress is low in the in-plane direction of the peeling layer 31. Hence, according to the present embodiment, favorable cutout can be performed while lowering the cutoff stress with a simple configuration.

### (Third Embodiment)

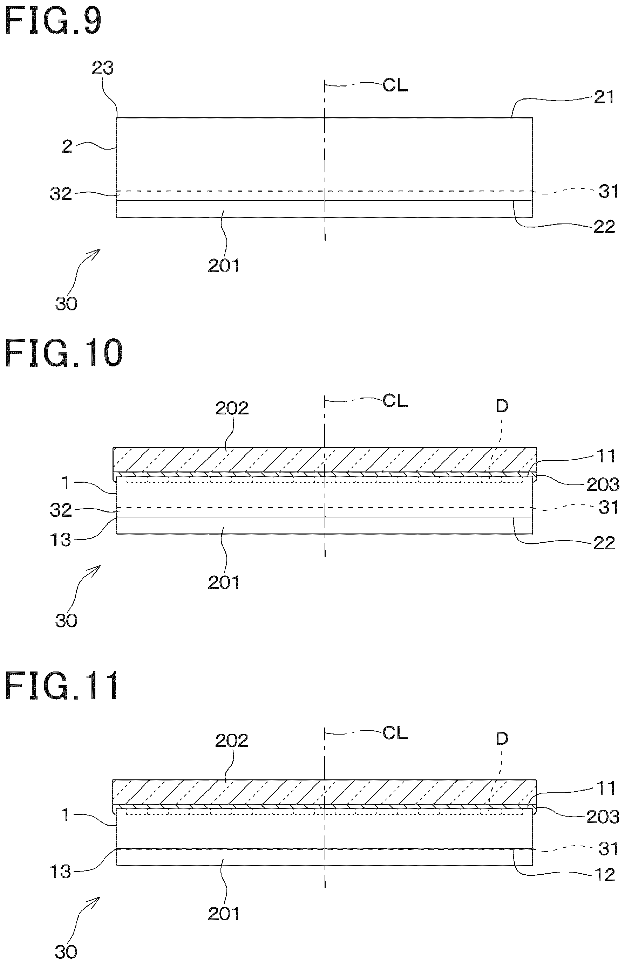

Hereinafter, a third embodiment of the present disclosure will be described. According to the present embodiment, as shown in Fig.9, the peeling object 30 is a joint body of the semiconductor ingot 2 as a single crystal body and a supporting substrate 201. The supporting substrate 201 is joined to a second ingot major surface 22 as a major surface closely positioned to the peeling layer 31 in the semiconductor ingot 2. The supporting substrate 201 may be formed of a silicon semiconductor or the like for example. The present disclosure may suitably be applied to the above-described peeling object 30.

Specifically, for example, an incomplete junction portion in which a direct junction between the second ingot major surface 22 and the supporting substrate 201 is not completed may be produced in the vicinity of the ingot outer peripheral edge 23. If such an incomplete junction portion is produced, in the case where the cutoff is performed from the ingot outer peripheral edge 23 as a starting point, a wafer crack may be produced from a boundary portion between the complete junction portion and the incomplete junction portion on the second ingot major surface 22.

In this respect, according to the present embodiment, even if such an incomplete junction portion is produced, a stress-concentrated region is caused to be formed in the peeling layer 31 inside the ingot outer peripheral edge 23 in the radial direction, whereby cracks can be propagated from the stress-concentrated region as a starting point. Thus, such above-described wafer cracks can be favorably prevented from being produced. The present embodiment may be applied to both the first embodiment and the second embodiment. In other words, positions of the stress-concentrated portion in the in-plane direction may be at a fixed position or may be set at an arbitrarily position.

### (Fourth Embodiment)

Hereinafter, a fourth embodiment of the present disclosure will be described. According to the present embodiment, as shown in Fig.10, the peeling object 30 is a joint body of a semiconductor wafer 1 as a single crystal body, a supporting substrate 201 and a device protection layer 202.

The semiconductor wafer 1 is provided with a surface device D formed on a wafer surface 11, as a semiconductor device such as a MOS transistor, a light emitting diode and the like. Further, a peeling layer 31 is formed inside the semiconductor wafer 1 between the wafer surface 11 and the wafer back surface 12 at a portion in a wafer back surface 12 side. In other words, the peeling layer 31 is provided along the wafer back surface 12. Then, the peeling object layer 32 is formed between the wafer back surface 12 and the peeling layer 31. The supporting substrate 201 is joined to the wafer back surface 12. The device protection layer 202 is a glass substrate or the like and joined to the wafer surface 11 via a junction layer 203 so as to protect the surface device D.

The present disclosure may suitably be applied to the peeling object 30 formed as described above. That is, according to the present embodiment, the stress-concentrated region is caused to be formed in the peeling layer 31 inside the wafer outer peripheral edge 13 in the radial direction, whereby caracks can be propagated from the stress-concentrated region as a starting point. Thus, such above-described wafer cracks can be favorably prevented from being produced. The present embodiment may be applied to both the first embodiment and the second embodiment. In other words, positions of the stress-concentrated portion in the in-plane direction may be at a fixed position or may be set at an arbitrarily position. The same applies to a fifth embodiment which will be described later.

### (Fifth Embodiment)

Hereinafter, a fifth embodiment according to the present disclosure will be described. Also, in the present embodiment, as shown in Fig.11, similar to the above-described fourth embodiment, the peeling object 30 is a joint body of a semiconductor wafer 1 as a single crystal body, a supporting substrate 201 and a device protection layer 202. However, according to the present embodiment, the peeling layer 31 is formed along a junction boundary surface between the semiconductor wafer 1 and the supporting substrate 201. That is, the peeling layer 31 is formed along the wafer back surface 12. Also, the present disclosure may suitably be applied to the above-described peeling object 30. That is, according to the present embodiment, effects and advantages similar to those in the above-described fourth embodiment can be obtained.

### (Modification Examples)

The present disclosure is not limited to the above-described embodiments. Hence, the above-described embodiments may appropriately be modified. Hereinafter, typical modification examples will be described. In the following explanation of the modification examples, configurations different from those in the above-described embodiments will be described. For the configurations mutually the same or equivalent between the above-described embodiments and the modification examples, the same reference signs are applied. Therefore, in the following explanations of the modification examples, explanations of the above-described embodiments will be appropriately applied to constituents having the same reference signs as those in the above-described embodiments unless any technical inconsistency or any additional explanations are present.

The present disclosure is not limited to a case where the semiconductor wafer 1 and the semiconductor ingot 2 are made of SiC semiconductor. In other words, the present disclosure may suitably be applied to other semiconductors such as Si, SiN, AlN and the like, for example.

The present disclosure is not limited to specific configurations disclosed in the above-described embodiments. That is, the peeling layer 31 may be formed in the first ingot major surface 21 side. Further, Fig.2 and the like are diagrams each showing a simplified overall configuration in order to describe an overview of a peelingjig 100 used for the present disclosure and a manufacturing method of a semiconductor wafer capable of being embodied by using the peeling jig 100. Hence, the configuration of the peeling jig 100 which is actually manufactured and sold is not necessarily the same as the configuration exemplified in Fig.2 and the like. Further, the configuration of the peeling jig 100 actually manufactured and sold may be appropriately modified from a typical configuration exemplified in Fig.2 and the like. Accordingly, for example, referring to Fig.3, an engaging or a coupling between the engaging hole 126 and the engaging part 127 can be embodied by using means other than using a screw.

The present disclosure is not limited to the specific configurations as described above. For example, the peeling layer 31 is not limited to one formed by laser irradiation marks. That is, the present disclosure may suitably be applied to a peeling object 30 having a peeling layer 31 formed using a method other than the laser irradiation. Hence, the present disclosure is suitably applied to a peeling process with a so-called laser slicing technique. However, it is not limited thereto.

In the above-described embodiments, elements constituting the embodiments are not necessarily required except that elements are clearly specified as necessary or theoretically necessary. Even in the case where numeric values are mentioned in the above-described embodiments, such as the number of constituents, numeric values, quantity, range or the like, it is not limited to the specific values unless it is specified as necessary or theoretically limited to specific numbers. In the case where materials, shapes, positional relationships and the like are mentioned for the constituents in the above-described embodiments, it is not limited to the material, shapes, directions and positional relationships except that they are clearly specified or theoretically limited to specific material, shapes, directions, positional relationships and the like.

For the modification examples, it is not limited to the above-described examples. That is, for example, other than the above-described examples, a plurality of embodiments may be mutually combined unless any technical inconsistency is present. Similarly, a plurality of modification examples may be mutually combined unless any technical inconsistency is present.

### (Aspects of the disclosure)

As is clear from the description of the above-described embodiments and modification examples, with the present specification and the drawings, at least the following items are disclosed. Note that the present disclosure is not limited to the following items
[First aspect] A method for manufacturing a semiconductor wafer, the method comprising steps of:
   preparing a peeling object (30) including a single crystal body (1, 2) of a semiconductor formed in a column shape or a plate shape having a pair of major surfaces composed of front and back surfaces, the peeling object having a peeling layer (31) provided along at least one of the major surfaces;
   applying a tensile stress to the peeling object to cause a first major surface and a second major surface of the pair of major surfaces to be separated from each other;
   forming, with an application of the tensile stress to the peeling object, a stress-concentrated region in the peeling layer which is positioned inside an outer peripheral edge (13, 23) in a radial direction of which the center is a center axis (CL) orthogonal to the major surface of the single crystal body; and
   propagating cracks from the stress-concentrated region as a starting point, thereby peeling between a first side portion and a second side portion of the peeling object having the peeling layer interposed therebetween in a direction parallel to the center axis.
[Second aspect] The method according to first aspect, wherein
   the semiconductor is made of SiC.
[Third aspect] The method according to first aspect or second aspect, wherein
   the peeling object is a joint body of the single crystal body and a supporting substrate (201).
[Fourth aspect] The method according to third aspect, wherein
   the peeling object includes a semiconductor wafer (1) as the single crystal body in which a surface device (D) is formed on a wafer surface (11) as the first major surface; a device protection layer (202) joined to the wafer surface so as to protect the surface device; and the supporting substrate joined to a wafer back surface (12) as the second major surface, and
   the peeling layer is provided along the wafer back surface.
[Fifth aspect] The method according to any one of aspects 1 to 4 comprising steps of:
   using a peeling jig (100) provided with a first jig body (112) that supports the peeling object in a first major surface side, a second jig body (122) that supports the peeling object in a second major surface side, a tensile joint (111, 121) provided protruding from the first jig body or the second jig body along the center axis;
   arranging the tensile joint inside the outer peripheral edge in the radial direction; and
   applying an external force to the tensile joint such that the tensile joint is separated from the single crystal body, thereby causing a peeling in the peeling layer from a starting point which is a position corresponding to the tensile joint in an in-plane direction along the major surface.
[Sixth aspect] The method according to fifth aspect, wherein
   the peeling jig is provided with a first tensile joint (111) as the tensile joint provided protruding from the first jig body along the center axis, and a second tensile joint (121) as the tensile joint provided protruding from the second jig body along the center axis; and
   applying an external force such that the first tensile joint and the second tensile joint are separated with each other.
[Seventh aspect] The method according to fifth aspect or sixth aspect, wherein
   the peeling jig is configured such that a position of the tensile joint in the in-plane direction is variable.
[Eighth aspect] The method according to any one of first to seventh aspects, wherein
   the peeling layer is formed of laser irradiation marks.

## Claims

1. A method for manufacturing a semiconductor wafer, the method comprising steps of:
preparing a peeling object (30) including a single crystal body (1, 2) of a semiconductor formed in a column shape or a plate shape having a pair of major surface composed of front and back surfaces, the peeling object having a peeling layer (31) provided along at least one of the major surfaces;
applying a tensile stress to the peeling object to cause a first major surface and a second major surface of the pair of major surface to be separated from each other;
forming, with an application of the tensile stress to the peeling object, a stress-concentrated region in the peeling layer which is positioned inside an outer peripheral edge (13, 23) in a radial direction of which the center is a center axis (CL) orthogonal to the major surface of the single crystal body; and
propagating cracks from the stress-concentrated region as a starting point, thereby peeling between a first side portion and a second side portion of the peeling object having the peeling layer interposed therebetween in a direction parallel to the center axis.

2. The method according to claim 1, wherein
the semiconductor is made of SiC.

3. The method according to claim 1, wherein
the peeling object is a joint body of the single crystal body and a supporting substrate (201).

4. The method according to claim 3, wherein
the peeling object includes a semiconductor wafer (1) as the single crystal body in which a surface device (D) is formed on a wafer surface (11) as the first major surface; a device protection layer (202) joined to the wafer surface so as to protect the surface device; and the supporting substrate joined to a wafer back surface (12) as the second major surface, and
the peeling layer is provided along the wafer back surface.

5. The method according to any one of claims 1 to 4 comprising steps of:
using a peeling jig (100) provided with a first jig body (112) that supports the peeling object on a first major surface side, a second jig body (122) that supports the peeling object on a second major surface side, a tensile joint (111, 121) provided protruding from the first jig body or the second jig body along the center axis;
arranging the tensile joint inside the outer peripheral edge in the radial direction; and
applying an external force to the tensile joint such that the tensile joint is separated from the single crystal body, thereby causing peeling in the peeling layer from a starting point which is a position corresponding to the tensile joint in an in-plane direction along the major surface.

6. The method according to claim 5, wherein
the peeling jig is provided with a first tensile joint (111) as the tensile joint provided protruding from the first jig body along the center axis, and
a second tensile joint (121) as the tensile joint provided protruding from the second jig body along the center axis; and
applying an external force such that the first tensile joint and the second tensile joint are separated with each other.

7. The method according to claim 5, wherein
the peeling jig is configured such that a position of the tensile joint in the in-plane direction is variable.

8. The method according to claim 1, wherein
the peeling layer is formed of laser irradiation marks.
